(19) 

Europäisches
Patentamt
European
Patent Office
Office européen
des brevets

(11) **EP 2 152 049 B1**

(12) **EUROPEAN PATENT SPECIFICATION**

(45) Date of publication and mention
of the grant of the patent:
**17.07.2013 Bulletin 2013/29**

(51) Int Cl.:
***H05K 1/02*** *(2006.01)*

(21) Application number: **08305459.3**

(22) Date of filing: **08.08.2008**

(54) **System for transmitting a signal, in particular a differential signal**

System zur Übertragung eines Signals, insbesondere eines Differentialsignals

Système pour la transmission d'un signal, en particulier un signal différentiel

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**10.02.2010 Bulletin 2010/06**

(73) Proprietor: **Alcatel Lucent**
**75007 Paris (FR)**

(72) Inventors:
• **Peron, Daniel**
**22300 Lannion (FR)**
• **Geffroy, Pascal**
**22700 Louannec (FR)**

• **Grimaud, Jean-Yves**
**22560 Pleumeur-Bodou (FR)**

(74) Representative: **Therias, Philippe**
**Alcatel-Lucent International**
**IP&S**
**32, avenue de Kléber**
**92700 Colombes (FR)**

(56) References cited:
**EP-A- 0 601 829     US-A1- 2004 085 149**
**US-A1- 2005 067 187     US-A1- 2005 077 977**
**US-A1- 2005 099 240     US-A1- 2006 160 428**
**US-B1- 6 420 778**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to the systems for transmitting signals, in particular differential signals.

A differential signal is a signal built from two complementary signals sent on two separate electrically conductive elements, for instance paths of a printed circuit board. The two complementary signals are transmitted from an emitting element to a receiving element which reads the difference between the two complementary signals, corresponding to the differential signal. The paths that transmit the complementary signals constitute a pair of paths.

Generally, a system for transmitting differential signals comprises at least two pairs of parallel paths able to transmit a differential signal. For instance, a first pair enables to transmit a differential signal from a first device to a second device and a second pair enables to transmit a differential signal from the second device to the first device.

It is known that a signal transmitted in a path generates in an other path a noise signal that perturbs the transmission of the main signal - i.e. the signal containing information - by this path. This phenomenon is called "crosstalk noise". In particular, the noise signal generated by paths of a first pair in paths of a second pair can perturb the differential signal originated from the second pair.

To address this problem, it is known to space away the two pairs of paths on the printed circuit board. The noise signal generated by the first path in the second path indeed diminishes as the distance between these paths increases. As a result, on the printed circuit board, the distance between a path of the first pair and a path of the second pair is far greater than the distance between paths of the same pair.

The above-mentioned system of the state of the art is satisfying concerning the influence of the crosstalk noise on the differential signals transmitted by the system but not in accordance with the tendency to reduce the dimensions and the complexity of the printed circuit boards. In such a system, the maximum density of interconnection is indeed limited by the great distance that must be set between the paths of each pair.

Document US2005/099240 discloses an arrangement of differential pairs in a multi-layer printed circuit board for eliminating crosstalk. Document US2005/067187 discloses a printed circuit board and a routing scenario thereof. The printed circuit board includes three dielectric layers, two signal layers and several differential pairs. Some differential pairs are disposed in one signal laver, while some differential pairs are interleavingly disposed in the adjacent other signal layer.

Document US2006/160428 deals with a communications jack assembly. A first pair of conductors is sandwiched inside a second pair of conductors. The second pair of conductors includes a crossover, the positioning of crossover being selected to provide differential to common mode crosstalk compensation.

Document EP0601829 discloses twisting individual wires of a conductor pair with wires of another conductor pair.

In accordance with an aspect of the invention, a system for transmitting differential signals is provided as defined in claim 1. Particular features of this system are provided as defined in claims 2 to 10.

However, none of the above known documents disclose the advantageous features of the present invention".

In accordance with yet another aspect of the invention a method for manufacturing a printed circuit is provided as defined in claim 11. Particular feature of this method is provided as defined in claim 12.

An object of the invention is to increase the density of paths on printed circuit boards without increasing the perturbation of the differential signal transmitted in the paths of the first, respectively the second, pair by the signals transmitted by the paths of the second, respectively the first, pair.

According to the invention, we provide a system for transmitting differential signals, as described in claim 1.

Thus, the path of the first pair, arranged between the paths of the second pair, generates a noise signal in each path of the second pair. As the differential signal generated by the second pair is constituted by the difference of the signal transmitted by a predetermined path of the second pair, called positive path, and of the signal transmitted by the other path of the second pair, called negative path, the noise signal generated by the path of the first pair in the negative path is substracted from the noise signal generated by the path of the first pair in the positive path.

The arrangement of the paths relative to each other, in particular the distance between the path of the first pair and each of the path of the second pair, can be chosen so that the perturbation due to the crosstalk noise of the differential signal transmitted by the second pair is very little, and even null.

As a matter of fact, the system of the invention is not aimed at diminishing the noise signal generated by the paths of the first pair in the paths of the second pair but enables to compensate the noise signal generated by the paths of the first pair in each path of the second pair. Distances between the paths are preferably chosen so that a noise signal generated by the paths from the first, respectively the second, pair in one of the paths of the second, respectively the first, pair is the same as a noise signal generated by the paths from the first, respectively the second, pair in the other path of the second, respectively the first, pair.

Consequently, the total space taken by the two pairs of paths can be diminished. Thus, the price of the system is also diminished.

It will be noted that the paths are parallel relative to each other on most of their length, the distances between the paths being easy to measure.

The system of the invention can also comprise one or more of the characteristics listed below:

- the paths of the first pair are alternated with the paths of the second pair, which enables to diminish the perturbation of the noise signal in both differential signals,
- a first path, belonging to the first pair, is situated between the paths of the second pair and a second path, belonging to the second pair, is situated between the paths of the first pair, a distance between the first and second paths being inferior to a distance between the first path and each of the other paths. Indeed, one of the paths of a pair (for instance, the first path) often transmits a positive signal while the other path (for instance, a path of the first pair referred to as fourth path) transmits a negative signal. The positive noise signal generated by the first path in the second path is greater than the positive noise signal generated by the first path in the other path of the second pair, referred to as third path. The positive noise signal generated in the second path can therefore be partly compensated by the positive noise signal generated in the third path (which is substracted to the noise signal generated in the second path) and partly compensated by the negative noise signal generated by the fourth path in the second path (the influence of the fourth path on the third path being considered as negligible). As a matter of fact, with this kind of arrangement, the influence of the crosstalk noise on the differential signal originated from the second pair can be very little, or even null,
- the distance between the first and second paths can also be inferior to a distance between the second path and each of the other paths. As a matter of fact, with this kind of arrangement, the influence of the crosstalk noise on the differential signal originated from the first pair can be very little, or even null,
- a distance between the first path and a third path, belonging to the second pair, is equal to a distance between the second path and a fourth path, belonging to the first pair. It enables to optimise the cancellation of the crosstalk noise in the differential signals,
- a ratio of the distance between the first and second paths to the distance between the first and third paths is comprised between 0.5 and 1, more particularly between 0.6 and 0.8. This value has been calculated as an ideal value that enables to greatly diminish the crosstalk noise in differential signals, and also to take into account other important parameters of the circuit, such as parameters relative to the controlled impedance,
- a ratio of the distance between the first and second paths to the distance between the second and fourth paths is also preferably comprised between 0.5 and 1, more particularly between 0.6 and 0.8, for the above-mentioned reasons,
- the system comprises at least a printed circuit board presenting the two pairs of paths,
- the system comprises a backplane comprising at least two superposed printed circuit boards, at least one printed circuit board presenting the two pairs of paths. The system is particularly advantageous in this case. Indeed, backplanes comprise several superposed layers of printed board circuit and connectors designed to be associated to complementary elements for connecting devices, such as complementary connection pins. A pin of a device connected to the backplane goes through every layer of printed circuit board. However, the part of the pin that carries current is the part situated between an extremity of the pin connected to the device and the layer of the backplane to which it is connected. The remaining length of the pin is not useful and generates furthermore perturbation in the signals that circulate on the pin, in particular as regards high frequency signals. This phenomenon is called "stub effect" and the techniques to attenuate the stub effect, as counterboring, are complex and cost a lot a time and money. Thanks to the invention, the density of the paths being increased, the number of layers is diminished, as is the total width of the backplane and the length of the complementary connecting pins. The noise generated in the differential signals because of the stub effect is therefore greatly diminished and it is no more worth to use expensive techniques to improve the characteristics of the backplane as regards the stub effect. A backplane of a system according to the invention is therefore much cheaper and easier to make,
- each path of the two pairs is designed to be connected to one device at each of its extremity, all the paths being connected to the same first and second devices, the first pair being more particularly designed to transmit a differential signal from the first device to the second device and the second pair being designed to transmit a differential signal from the second device to the first device.

According to the invention, we also provide a fabrication process of a printed circuit board, wherein at least four electrically conductive paths are created on the board, the paths being arranged so that:

- a distance between each external path and a corresponding adjacent internal path is the same, and
- a distance between an external path and the adjacent internal path is superior to a distance between the two internal paths, preferably less than twice superior.

Each external path and the internal path which is not adjacent to the external path can form a pair of paths able to transmit a differential signal.

The invention will be better understood thanks to the following description of the invention, which describes only examples of systems according to the invention and refers to the drawings, in which :

-    figure 1 is a view of a printed circuit board of a system according to a mode of construction of the invention,
-    figure 2 is a schematic section view of a part of the printed circuit board of figure 1 according to II-II,
-    figure 3A is a schematic section view of a system of the state of the art,
-    figure 3B is a representation of a noise signal generated by crosstalk noise in the system of figure 3A, in function of time,
-    figure 4A is a schematic section view of a system according to another mode of construction of the invention,
-    figure 4B is a representation of a noise signal generated by crosstalk noise in the system of figure 4A, in function of time.

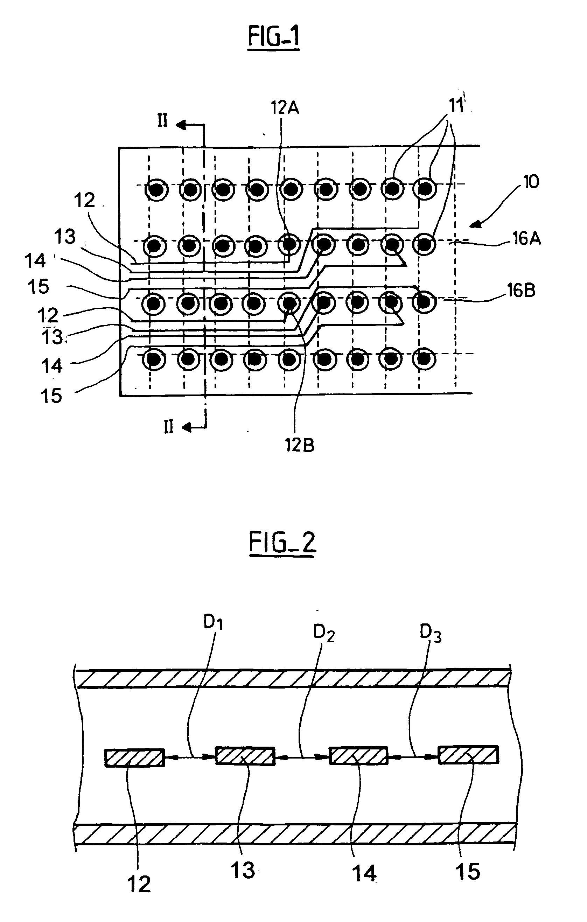

Figure 1 represents a printed circuit board 10 of a backplane of a system according to a mode of construction of the invention. A backplane comprises several superposed circuit board, of general configuration essentially identical to the printed circuit board shown on figure 1.

The printed circuit board 10 is realized in an electrically insulating material, such as plastic material, for instance epoxy resin. It comprises four rows of vias 11. These vias 11 are configured to receive connecting pins (not represented) of at least a device, the connecting pins being press-fitted in the vias 11. The connecting pins go through the vias of every layer of the backplane.

The printed circuit board 10 also comprises four electrically conductive paths 12 to 15, each of these paths comprising two extremities 12A, 12B; 13A, 13B; 14A, 14B; 15A, 15B and being electrically connected to a via at each of its extremities. In particular, each path connects a via of the second row 16A with a via of the third row 16B. The paths 12 to 15 carry current between these vias, for instance the path 12 carries current from the via 12A to the via 12B. The current carried by these paths enables to transmit signals containing information.

The paths are made of metal , for instance copper. They are parallel to each other on the majority of their length, more precisely on more than 90% of their length. Only at their extremities they are not parallel.

The paths 12, 14 constitute a first pair of paths that transmit a first differential signal, called TX, from a first device (not represented), for instance an Ethernet switch, connected to the second row 16A of connectors to a second device (not represented), for instance a graphic card, connected to the third row 16B of connectors. The differential signal TX is constituted by the signal transmitted by the path 12 to which is substracted the signal transmitted by the path 14. The signals received from the paths 12, 14 are handled by the second device to reconstitute the differential signal TX.

The paths 13, 15 constitute a second pair of paths that transmit a second differential signal, called RX, from the second device to the first device. The differential signal RX is constituted by the signal transmitted by the path 15 to which is substracted the signal transmitted by the path 13. The signals received from the paths 13, 15 are handled by the first device to reconstitute the differential signal RX.

The path 12 transmits a signal which is null or positive with an amplitude of +Amp1 Volts, whereas the path 14 transmits a signal which is null or negative with an amplitude of -Amp1 Volts. The path 15 transmits a signal which is null or positive with an amplitude of +Amp2 Volts, whereas the path 13 transmits a signal which is null or negative with an amplitude of -Amp2 Volts.

The paths 12, 14 of the first pair are alternated with paths 13, 15 of the second pair. Path 14 corresponds to a first path, path 13 corresponds to a second path, path 15 corresponds to a third path and path 12 corresponds to a fourth path.

The paths 12, 15 situated at the extremities of the arrangement are called external paths while paths 13, 14 situated between paths 12, 15 are called internal paths.

The relative arrangement of the paths will be detailed in reference to figure 2, which is a section view of a part a layer of the backplane according to II-II.

A distance between the paths 12 and 13 is referred to as $D_1$, a distance between the paths 13 and 14 is referred to as $D_2$ and a distance between the paths 14 and 15 is referred to as $D_3$. As can be seen on figure 2, distances $D_1$ and $D_3$ are equal while distance $D_2$ is smaller than distances $D_1$, $D_3$.

This arrangement enables to cancel the crosstalk noise generated in the differential signals. It is considered that only the signals circulating in an adjacent path of a given path perturb the signal circulating in the given path. The noise signal $S_n$ in the given path generated by a signal circulating in an adjacent path is the expressed as follows:

$$S_n = \frac{C \times S_a}{D}$$ , wherein $S_a$ is the signal circulating in the adjacent path, $D$ is the distance between the given and adjacent paths and $C$ is a constant depending on the electrical field.

Concerning the system of figure 2, the noise signals generated in path 12 only originates from the path 13 and is expressed as follows:

$$S_{n12} = S_{n13\to12} = \frac{C\times(-Amp2)}{D_1}$$

The noise signal generated in path 14 originates from paths 13 and 15. It is expressed as follows:

$$S_{n14} = S_{n13\to14} + S_{n15\to14} = \frac{C\times(-Amp2)}{D_2} + \frac{C\times(+Amp2)}{D_3}$$

Therefore, the influence of the crosstalk noise on the differential signal transmitted by the first pair $S_{n(pair1)}$ is calculated by substracting the noise signal generated in path 14 to the noise signal generated in path 12.

$$S_{n(pair1)} = S_{n12} - S_{n14} = C\times Amp2 \times\left(\frac{1}{D_2} - \frac{1}{D_1} - \frac{1}{D_3}\right)$$

As $D_1=D_3=2D_2$, $\quad S_{n(pair1)} = C\times Amp2 \times\left(\frac{1}{D_2} - \frac{2}{2\times D_2}\right) = 0$

The influence of the crosstalk can therefore be cancelled in the differential signal transmitted by the first pair.
Concerning the other pair, the noise signals generated in paths 13 and 15 are expressed as follows:

$$S_{n13} = S_{n12\to13} + S_{n14\to13} = \frac{C\times(+Amp1)}{D_1} + \frac{C\times(-Amp1)}{D_2}$$

$$S_{n15} = S_{n14\to15} = \frac{C\times(-Amp1)}{D_3}$$

The influence of the crosstalk noise on the differential signal generated by this second pair is therefore null, too:

$$S_{n(pair2)} = S_{n15} - S_{n13} = C\times Amp1 \times\left(\frac{1}{D_2} - \frac{1}{D_3} - \frac{1}{D_1}\right) = 0$$

This arrangement of paths 12 to 15 therefore enables to eliminate the crosstalk noise in the differential signals generated by the pairs of paths 12, 14 and 13, 15. Moreover, as the only parameters to take into account to cancel the crosstalk noise are the ratios of the distances $\dfrac{D_2}{D_1}$ and $\dfrac{D_3}{D_1}$, the value of distances $D_1$ to $D_3$ does not matter and can be diminished.

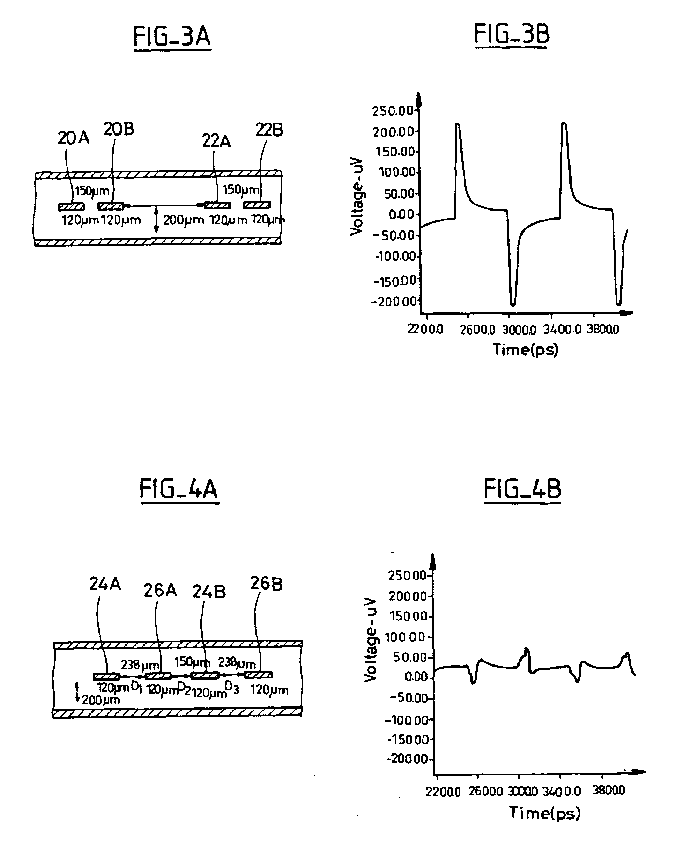

The comparison of the system according to the invention and of a system of the state of the art will be done in reference to Figures 3A, 3B and 4A, 4B.
As can be seen, figure 3A is a view analogous to the one of figure 2, but for a system of the state of the art. This system also comprises four paths 20A, 20B, 22A, 22B, which are parallel to each other on most of their length. The paths 20A and 20B form a first pair of paths that generates a first differential signal. The paths 22A and 22B form a second pair of paths that generates a second differential signal.

The two paths of a same pair are adjacent and the distance between two paths of a same pair is far smaller than the distance between the path 20B of the first pair and the path 22A of the second pair, these two paths being adjacent. The pairs of paths are intentionally spaced away in this system to avoid crosstalk noise in the differential signals generated by these pairs.

Figure 4A is also a view analogous to the one of figure 2, representing a system according to another mode of construction of the invention.

The system represented on figure 4A is the same as the one represented on figure 2, the paths 24A, 24B and 26A, 26B forming respectively a first and a second pair of paths that generate a differential signal. The only difference between the system of figure 2 and the system of figure 4A is that the ratio $\dfrac{D'_2}{D'_1} \neq 0.5$ (D'1 being the distance between the paths 24A and 26A and D'2 being the distance between the paths 26A and 24B). This ratio is comprised between 0.6 and 0.8. This value is an optimised value taking into account other parameters than the parameters relative to the crosstalk noise, for instance parameters relative to the controlled impedance.

It will be noted that the total breadth of the arrangement of paths is far greater as regards the system of the state of the art.

Figures 3B and 4B represent the noise signal measured in one of the pairs of the system, generated by the signals circulating in the paths of the other pair. The signal circulating in the other pair is the same for the system of the state of the art and for the system according to the invention. This signal is obtained by measuring the differential signal received by an inactive pair. If this pair was active, this noise signal superposes itself to the main signal, containing information, and perturbs it. As can be seen on figure 3B and 4B, the noise signal has approximatively the same evolution in the system of the state of the art and in the system according to the invention, but the amplitude of the noise signal is four to five times superior in the system of the state of the art.

As a matter of fact, the system according to the invention enables to diminish the crosstalk noise in differential signals generated by pairs of paths of the system and, as a matter of fact, to maximize the density of interconnection on the printed circuit board.

It will be noted that the invention is not limited to the above-mentioned mode of construction. For instance, the two pairs of paths can lead to distinct devices. Moreover, the ratio of the distance between the two internal paths to the distance between an internal path and an adjacent external path is not set obligatory to 0.5 or between 0.6 to 0.8.

## Claims

1. A system (10) for transmitting differential signals, which comprises at least first and second pairs of electrically conductive paths (12 -15; 24A, 24B, 26A, 26B), at least one of the paths (13; 14; 26A; 24B) of the first pair being arranged between the paths (12, 14; 13, 15; 24A, 24B; 26A, 26B) of the second pair,
**characterized in that** a first path (14; 24B), belonging to the first pair (12, 14; 24A, 24B) is situated between the paths (13, 15; 26A, 26B) of the second pair and a second path (13 ; 26A) belonging to the second pair is situated between the paths (12, 14; 24A, 24B) of the first pair, a distance between the first (14; 24B) and second (13 ; 26A) paths being inferior to a distance between the first path (14; 24B) and each of the other paths (12, 13, 15; 24A, 26A, 26B).

2. The system according to claim 1, in which paths of the first pair are alternated with paths of the second pair.

3. The system according to claim 2, wherein the distance between the first (14; 24B) and second (13 ; 26A) paths is inferior to a distance between the second path (13 ; 26A) and each of the other paths (12, 14, 15; 24A, 24B, 26B).

4. The system according to claim 2 or 3, wherein a distance between the first path (14; 24B) and a third path (15, 26B), belonging to the second pair (13, 15; 26A, 26B) and distinct from the second path, is equal to a distance between the second path and a fourth path (12, 24A), belonging to the first pair and distinct from the first path.

5. The system according to any of claims 2 to 4, wherein a ratio of the distance between the first (14; 24B) and second (13 ; 26A) paths to the distance between the first (14; 24B) and third (15, 26B) paths is comprised between 0.5 and 1, more particularly between 0.6 and 0.8.

6. The system according to any of claims 2 to 5, wherein a ratio of the distance between the first (14; 24B) and second (13 ; 26A) paths to the distance between the second (13 ; 26A) and fourth (12, 24A) paths is comprised between 0.5 and 1, more particularly between 0.6 and 0.8.

7. The system according to any of claims 1 to 6, wherein distances between the paths are chosen so that a noise signal generated by the paths from the first, respectively the second, pair in one of the paths of the second, respectively the first, pair is the same as a noise signal generated by the paths from the first, respectively the second, pair in the other path of the second, respectively the first, pair.

8. The system according to any of the claims 1 to 7, comprising at least a printed circuit board (10) presenting the two pairs of paths (12 -15; 24A, 24B, 26A, 26B).

9. A system according to any of claims 1 to 8, comprising a backplane comprising at least two superposed printed circuit boards, at least one printed circuit (10) board presenting the two pairs of paths (12 -15; 24A, 24B, 26A, 26B).

10. A system according to any of claims 1 to 9, wherein each path (12 -15; 24A, 24B, 26A, 26B) of the two pairs is designed to be connected to one device at each of its extremity, all the paths being connected to the same first and second devices, the first pair (12, 14; 24A, 24B) being more particularly designed to transmit a differential signal from the first device to the second device and the second pair (13, 15; 26A, 26B) being designed to transmit a differential signal from the second device to the first device.

11. A manufacturing process of a printed circuit board (10), wherein at least four electrically conductive paths (12 -15; 24A, 24B, 26A, 26B) are created on the board, **characterized in that** the paths are arranged so that:

    - a distance between each external path (12, 15; 24A, 26B) and a corresponding adjacent internal path (13, 14; 26A, 24B) is the same, and
    - a distance between an external path (12, 15; 24A, 26B) and the adjacent internal path (13, 14; 26A, 24B) is superior to a distance between the two internal paths, preferably less than twice superior.

12. The manufacturing process of claim 11, in which each external (12; 15) path and the internal path (14; 13) which is not adjacent to the external path form a pair of paths able to transmit a differential signal.


**Patentansprüche**

1. System (10) zum Übertragen von Differenzsignaten, welches mindestens ein erstes und ein zweites Paar von elektrisch leitenden Pfaden (12 - 15; 24A, 24B, 26A, 26B) umfasst, wobei mindestens einer der Pfade (13; 14; 26A; 24B) des ersten Paares zwischen den Pfaden (12, 14; 13, 15; 24A, 24B; 26A, 26B) des zweiten Paares eingerichtet ist, **dadurch gekennzeichnet, dass** ein erster Pfad (14; 24B), welcher dem ersten Paar (12, 14; 24A, 24B) angehört, zwischen den Pfaden (13, 15; 26A, 26B) des zweiten Paares angeordnet ist, und ein zweiter Pfad (13; 26A), welcher dem zweiten Paar angehört, zwischen den Pfaden (12, 14; 24A, 24B) des ersten Paares angeordnet ist, wobei ein Abstand zwischen dem ersten (14; 24B) und dem zweiten (13; 26A) Pfad kleiner ist als ein Abstand zwischen dem ersten Pfad (14; 24B) und einem jeden der anderen Pfade (12, 13, 15; 24A, 26A, 26B).

2. System nach Anspruch 1, wobei Pfade des ersten Paares alternierend mit Pfaden des zweiten Paars angeordnet sind.

3. System nach Anspruch 2, wobei der Abstand zwischen dem ersten (14; 24B) und dem zweiten (13; 26A) Pfad kleiner ist als der Abstand zwischen dem zweiten Pfad (13; 26A) und einem jeden der anderen Pfade (12, 14, 15; 24A, 24B, 26B).

4. System nach Anspruch 2 oder 3, wobei der Abstand zwischen dem ersten Pfad (14; 24B) und einem dritten Pfad (15, 26B), welcher dem zweiten Paar (13, 15; 26A, 26B) angehört und sich von dem zweiten Pfad unterscheidet, gleich dem Abstand zwischen dem zweiten Pfad und einem vierten Pfad (12, 24A), welcher dem ersten Paar (12, 24A) angehört und sich von dem ersten Pfad unterscheidet, ist.

5. System nach einem beliebigen der Ansprüche 2 bis 4, wobei ein Verhältnis des Abstands zwischen dem ersten (14; 24B) und dem zweiten (13; 26A) Pfad zum Abstand zwischen dem ersten (14; 24B) und dem dritten (15, 26B) Pfad zwischen 0,5 und 1, insbesondere zwischen 0,6 und 0,8, beträgt.

**6.** System nach einem beliebigen der Ansprüche 2 bis 5, wobei ein Verhältnis des Abstands zwischen dem ersten (14; 24B) und dem zweiten (13; 26A) Pfad zum Abstand zwischen dem zweiten (13; 26A) und dem vierten (12, 24A) Pfad zwischen 0,5 und 1, insbesondere zwischen 0,6 und 0,8 beträgt.

**7.** System nach einem beliebigen der Ansprüche 1 bis 6, wobei die Abstände zwischen den Pfaden derart gewählt werden, dass ein von den Pfaden aus dem ersten, beziehungsweise dem zweiten, Paar in einem der Pfade des zweiten, beziehungsweise des ersten, Paares erzeugtes Rauschsignal dasselbe ist wie ein von den Pfaden aus dem ersten, beziehungsweise dem zweiten, Paar in dem anderen Pfad des zweiten, beziehungsweise des ersten, Paares erzeugtes Rauschsignal.

**8.** System nach einem beliebigen der Ansprüche 1 bis 7, umfassend mindestens eine Leiterplatte (10) mit den zwei Pfadpaaren (12 - 15; 24A, 24B, 26A, 26B).

**9.** System nach einem beliebigen der Ansprüche 1 bis 8, umfassend eine Rückwand mit mindestens zwei übereinander angeordneten Leiterplatten, wobei mindestens eine Leiterplatte (10) mit den beiden Pfadpaaren (12 - 15; 24A, 24B, 26A, 26B) versehen ist.

**10.** System nach einem beliebigen der Ansprüche 1 bis 9, wobei jeder Pfad (12 - 15; 24A, 24B, 26A, 26B) der zwei Paare für den Anschluss an eine Vorrichtung an einem jeden seiner Enden vorgesehen ist, wobei alle Pfade an dieselbe erste und zweite Vorrichtung angeschlossen werden, wobei das erste Paar (12, 14; 24A, 24B) insbesondere für die Übertragung eines Differenzsignals von der ersten Vorrichtung an die zweite Vorrichtung vorgesehen ist und das zweite Paar (13, 15; 26A, 26B) insbesondere für die Übertragung eines Differenzsignals von der zweiten Vorrichtung an die erste Vorrichtung vorgesehen ist.

**11.** Herstellungsverfahren für eine Leiterplatte (10), wobei mindestens vier elektrisch leitende Pfade (12 - 15; 24A, 24B, 26A, 26B) auf der Leiterplatte eingerichtet werden, **dadurch gekennzeichnet, dass** die Pfade derart angeordnet sind, dass:

- ein Abstand zwischen jedem äußeren Pfad (12, 15; 24A, 26B) und einem entsprechenden benachbarten inneren Pfad (13, 14; 26A, 24B) derselbe ist, und
- ein Abstand zwischen einem äußeren Pfad (12, 15, 24A, 26B) und dem benachbarten inneren Pfad (13, 14; 26A; 24B) größer als ein Abstand zwischen den beiden inneren Pfaden, vorzugsweise weniger als zweimal größer, ist.

**12.** Herstellungsverfahren nach Anspruch 11, wobei jeder äußere (12; 15) Pfad und der innere Pfad (14; 13), welcher nicht mit dem äußeren Pfad benachbart ist, ein Pfadpaar bilden, welches für die Übertragung eines Differenzsignals geeignet ist.

## Revendications

**1.** Système (10) pour transmettre des signaux différentiels, qui comprend au moins des première et deuxième paires de chemins électriquement conducteurs (12 à 15 ; 24A, 24B, 26A, 26B), au moins un des chemins (13 ; 14 ; 26A ; 24B) de la première paire étant disposé entre les chemins (12, 14 ; 13, 15 ; 24A, 24B; 26A, 26B) de la deuxième paire, **caractérisé en ce qu'**un premier chemin (14 ; 24B), appartenant à la première paire (12, 14 ; 24A, 24B) est situé entre les chemins (13, 15 ; 26A, 26B) de la deuxième paire et un deuxième chemin (13; 26A) appartenant à la deuxième paire est situé entre les chemins (12, 14 ; 24A, 24B) de la première paire, une distance entre le premier (14 ; 24B) et le deuxième (13 ; 26A) chemins étant inférieure à une distance entre le premier chemin (14 ; 24B) et chacun des autres chemins (12, 13, 15 ; 24A, 26A, 26B).

**2.** Système selon la revendication 1, dans lequel des chemins de la première paire alternent avec des chemins de la deuxième paire.

**3.** Système selon la revendication 2, dans lequel la distance entre les premier (14 ; 24B) et deuxième (13 ; 26A) chemins est inférieure à une distance entre le deuxième chemin (13 ; 26A) et chacun des autres chemins (12, 14, 15 ; 24A, 24B, 26B).

**4.** Système selon la revendication 2 ou 3, dans lequel une distance entre le premier chemin (14 ; 24B) et un troisième chemin (15, 26B), appartenant à la deuxième paire (13, 15 ; 26A, 26B) et distinct du deuxième chemin, est égale à une distance entre le deuxième chemin et un quatrième chemin (12, 24A), appartenant à la première paire et distinct du premier chemin.

5. Système selon l'une quelconque des revendications 2 à 4, dans lequel un rapport de la distance entre le premier (14 ; 24B) et le deuxième (13 ; 26A) chemins par rapport à la distance entre le premier (14 ; 24B) et le troisième (15, 26B) chemins est compris entre 0,5 et 1, plus particulièrement entre 0,6 et 0,8.

6. Système selon l'une quelconque des revendications 2 à 5, dans lequel un rapport de la distance entre le premier (14 ; 24B) et le deuxième (13 ; 26A) chemins par rapport à la distance entre le deuxième (13 ; 26A) et le quatrième (12, 24A) chemins est compris entre 0,5 et 1, plus particulièrement entre 0,6 et 0,8.

7. Système selon l'une quelconque des revendications 1 à 6, dans lequel des distances entre les chemins sont choisies de sorte qu'un signal de bruit généré par les chemins à partir de la première, respectivement la deuxième, paire dans un des chemins de la deuxième, respectivement la première, paire est identique à un signal de bruit généré par les chemins à partir de la première, respectivement la deuxième, paire dans l'autre chemin de la deuxième, respectivement de la première, paire.

8. Système selon l'une quelconque des revendications 1 à 7, comprenant au moins une carte de circuit imprimé (10) présentant les deux paires de chemins (12 à 15 ; 24A, 24B, 26A, 26B).

9. Système selon l'une quelconque des revendications 1 à 8, comprenant un fond de panier comprenant au moins deux cartes de circuits imprimés superposées, au moins une carte de circuit imprimé (10) présentant les deux paires de chemins (12 à 15 ; 24A, 24B, 26A, 26B).

10. Système selon l'une quelconque des revendications 1 à 9, dans lequel chaque chemin (12 à 15; 24A, 24B, 26A, 26B) des deux paires est conçu pour être connecté à un dispositif à chacune de ses extrémités, tous les chemins étant connectés aux mêmes premier et deuxième dispositifs, la première paire (12, 14 ; 24A, 24B) étant plus particulièrement conçue pour transmettre un signal différentiel à partir du premier dispositif vers le deuxième dispositif et la deuxième paire (13, 15 ; 26A, 26B) étant conçue pour transmettre un signal différentiel à partir du deuxième dispositif vers le premier dispositif.

11. Processus de fabrication d'une carte de circuit imprimé (10), dans lequel au moins quatre chemins électriquement conducteurs (12 à 15 ; 24A, 24B, 26A, 26B) sont créés sur la carte, **caractérisé en ce que** les chemins sont agencés de sorte que :

- une distance entre chaque chemin externe (12, 15; 24A, 26B) et un chemin interne adjacent correspondant (13, 14 ; 26A, 24B) est identique, et
- une distance entre un chemin externe (12, 15 ; 24A, 26B) et le chemin interne adjacent (13, 14; 26A, 24B) est supérieure à une distance entre les deux chemins internes, de préférence moins de deux fois supérieure.

12. Processus de fabrication selon la revendication 11, dans lequel chaque chemin externe (12 ; 15) et le chemin interne (14 ; 13), qui n'est pas adjacent au chemin externe, forment une paire de chemins pouvant transmettre un signal différentiel.

EP 2 152 049 B1

## FIG_1

## FIG_2

10

## FIG_3A

## FIG_3B

## FIG_4A

## FIG_4B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005099240 A
- US 2005067187 A
- US 2006160428 A
- EP 0601829 A